# EUROPEAN PATENT APPLICATION

(11) **EP 2 485 271 A1**
(43) Date of publication of application: **08.08.2012**
(21) Application number: 10820506.3
(22) Date of filing: 28.09.2010
(51) Int. Cl.: H01L 31/042, C09K 11/06

(54) **FLUORESCENT MATERIAL FOR CONVERTING WAVELENGTHS, RESIN COMPOSITION FOR CONVERTING WAVELENGTHS CONTAINING THE FLUORESCENT MATERIAL, SOLAR CELL MODULE PRODUCED USING THE FLUORESCENT MATERIAL OR THE RESIN COMPOSITION, PROCESS FOR PRODUCING RESIN COMPOSITION FOR CONVERTING WAVELENGTHS, AND PROCESS FOR PRODUCING SOLAR CELL MODULE**

(30) Priority: 29.09.2009 JP 2009224517
(71) Applicant: Hitachi Chemical Company, Ltd., Tokyo 163-0449 (JP)
(72) Inventor: OKANIWA, Kaoru, Tsukuba-shi Ibaraki 300-4247 (JP)
(74) Representative: Albrecht, Thomas
(86) International application number: PCT/JP2010/066781
(87) International publication number: WO 2011/040391

(57) **Abstract**

Disclosed is a fluorescent material for conversing wavelengths used in a light transmitting layer of a solar cell module, by mixing a fluorescent substance and a vinyl compound. Also, disclosed is a resin composition for converting wavelengths by polymerizing the vinyl compound of the fluorescent material for converting wavelengths and then mixing it with a transparent dispersion medium resin. Therefore, there can be provided a fluorescent material for converting wavelengths capable of converting a light that contributes less to solar energy generation in the incident solar radiation, to a wavelength that contributes significantly to energy generation, as well as utilizing the solar radiation efficiently and stably without deteriorating, a resin composition for converting wavelengths and methods for producing thereof.

## Description

### TECHNICAL FIELD

The present invention relates to a fluorescent material for converting wavelengths for use in solar cells, a resin composition for converting wavelengths containing the fluorescent material, a solar cell module using the fluorescent material and/or the resin composition, and methods for producing the resin composition and the solar cell module. More particularly, the present invention relates to a fluorescent material for converting wavelengths used in a solar cell module capable of increasing the energy generation efficiency by converting the wavelength of a light in a wavelength region that does not contribute to energy generation to that of a light in a wavelength region that contributes to energy generation, a resin composition for converting wavelengths, a solar cell module, and methods for producing the resin composition and the solar cell.

### BACKGROUND ART

Conventional silicon crystal solar cell modules have a configuration such as described below. As a protective glass (also called cover glass) located at the surface, reinforced glass is used to put emphasis on impact resistance, and one surface thereof is provided with concavities and convexities by embossing processing, in order to enhance the adhesiveness to a scaling material (usually, a resin containing an ethylene-vinyl acetate copolymer as a main component, also called a filler material).

The concavities and convexities are formed on the inner side, and the surface of the solar cell module is smooth. Furthermore, provided under the protective glass are a photovoltaic cell, a sealing material for protecting and sealing a tab line, and a back film (see, for example, Non-Patent Literature 1).

There have been suggested a number of techniques for providing a layer which emits a light in a wavelength that contributes significantly to energy generation, on the light-receiving surface of the solar cell by using a fluorescent substance (also called a light-emitting material), and converting the wavelength of a light in the ultraviolet region or in the infrared region that contributes less to energy generation in the solar radiation spectrum (see, for example, Patent Literatures 1 to 13).

There have also been suggested methods for incorporating a rare earth metal complex, which is a fluorescent substance, into a sealing material (see, for example, Patent Literatures 14 to 17).

Furthermore, conventionally, ethylene-vinyl acetate copolymers imparted with thermosettability have been widely used as transparent sealing materials for solar cells (see, for example, Patent Literatures 18 to 25).

### CITATION LIST

### PATENT LITERATURES

Patent Literature 1: Japanese Patent Application Laid-Open (JP-A) No. 2000-328053
Patent Literature 2: JP-A No. Hei 09-230396
Patent Literature 3: JP-A No. 2003-243682
Patent Literature 4: JP-A NO. 2003-218379
Patent Literature 5: JP-A No. Hei 11-345993
Patent Literature 6: JP-A. No. 2006-024716
Patent Literature 7: Japanese Patent Application Publication (JP-B) No. Hei 08-004147
Patent Literature 8: JP-A No. 2001-094128
Patent Literature 9: JP-ANo. 2001-352091
Patent Literature 10: JP-ANo. Hei 10-261811
Patent Literature 11: Japanese Patent No. 2660705
Patent Literature 12: JP-ANo. 2006-269373
Patent Literature 13: JP-A No. Sho 63-006881.
Patent Literature 14: JP-A No. 2008-195674
Patent Literature 15: JP-ANo. 2007-230955
Patent Literature 16: JP-A No. 2006-298974
Patent Literature 17: JP-A No. 2006-303033
Patent Literature 18: JP-A No. 2003-51605
Patent Literature 19: JP-A No. 2005-126708
Patent Literature 20: JP-A No. Hei 8-283696
Patent Literature 21: JP-A No. Hei 6-322334
Patent Literature 22: JP-A No. 2008-205448
Patent Literature 23: JP-ANo. 2008-118073
Patent Literature 24: JP-A No. 2008-159856
Patent Literature 25: JP-A No. 2000-183385

### NON-PATENT LITERATURES

Non-Patent Literature 1: Hamakawa, Yoshihiro, Ed., "Taiyoko Hatsuden (Solar Generation Generation)" - Latest Technology and Systems -, 2000, CMC Publishing, Co., LTD.

### SUMMARY OF THE INVENTION

### TECHNICAL PROBLEM

In the suggestions for converting the wavelength of a light in a wavelength region that contributes less to energy generation, to that of a light in a wavelength region that contributes significantly to energy generation, as disclosed in Patent Literatures 2 to 13, the wavelength converting layers contain fluorescent substances. However, these fluorescent substances generally have large refractive indices and shapes, and when incident solar radiation passes through a wavelength converting film, the proportion of solar radiation that does not sufficiently reach the photovoltaic cell due to scattering and then does not contribute to energy generation, increases. This scattering occurs because a fluorescent substance having a refractive index that is different from that of the medium, and having a large particle size, is dispersed in a transparent dispersion medium resin. As a result, there is a problem that even if light in the ultraviolet region is converted to light in the visible region at the wavelength conversion layer, the proportion of generated electric power with respect to incident solar radiation (energy generation efficiency) is not much increased.

Furthermore, in the methods described in Patent Literatures 14 to 17, the ethylene-vinyl acetate (EVA) that is widely used as a sealing material is prone to hydrolysis, and hydrolysis of EVA produces an acid. This acid not only causes acceleration of the hydrolysis and deterioration of rare earth metal complexes, but also impairs wavelength conversion.

The present invention was made to improve the problems such as described above, and an object of the present invention is to stably enhance the energy generation efficiency by enhancing the efficiency for light utilization in a solar cell module. For example, in a silicon crystal solar cell, light having a wavelength shorter than 400 nm and light having a wavelength longer than 1200 nm in the solar radiation are not utilized effectively, and about 56% of the solar radiation energy does not contribute to solar energy generation due to this spectral mismatch. The present invention is intended to overcome the spectral mismatch by achieving wavelength conversion using a fluorescent material for converting wavelengths which has excellent moisture resistance and satisfactory dispersibility, to utilize solar radiation efficiently and stably.

That is, the fluorescent material for converting wavelengths of the present invention is intended to have excellent moisture resistance and excellent dispersibility in a transparent dispersion medium resin as compared with the conventional rare earth metal complex fluorescent substances. Furthermore, the fluorescent material for converting wavelengths of the present invention converts a light in a wavelength region that contributes less to solar energy generation, in the incident solar radiation, to a light in a wavelength region that contributes significantly to energy generation. Moreover, a fluorescent material for converting wavelengths being obtainable by mixing a fluorescent substance and a vinyl compound, can give a resin composition for converting wavelengths which achieves a satisfactory dispersed state in a transparent dispersion medium resin. Accordingly, it is an object of the invention to efficiently introduce converted light to a photovoltaic cell without scattering, by using the resin composition for converting wavelengths in a light transmitting layer of a solar cell module.

### SOLUTION TO PROBLEM

The inventors of the present invention conducted a thorough investigation in order to address the problems described above, and as a result, they found that when a fluorescent substance is mixed with a vinyl compound, the mixture is capable of converting a light in a wavelength region that contributes less to solar energy generation, in the incident solar radiation, to a light in a wavelength region that contributes significantly to energy generation, and also, the mixture was excellent in moisture resistance and in dispersibility. Furthermore, a fluorescent material for converting wavelengths which is obtained by mixing a fluorescent substance with a vinyl compound, and optionally, then by polymerizing this mixture, is such that the fluorescent substance is dissolved or dispersed in the vinyl compound, and the fluorescent materials for converting wavelengths itself also achieves a satisfactory dispersed state in a transparent dispersion medium resin. Accordingly, the inventors found that when this resin material for converting wavelengths is used in a light transmitting layer of a solar cell module, light can be efficiently introduced into a photovoltaic cell with less scattering of the light, and thus the inventors finally completed the present invention.

Specifically, the present invention has a constitution as described below.

(1) A fluorescent material for converting wavelengths used in a light transmitting layer of a solar cell module being obtainable by mixing a fluorescent substance and a vinyl compound.

(2) The fluorescent material for converting wavelengths as set forth in the item (1), wherein the vinyl compound is an acrylic monomer and/or a methacrylic monomer.

(3) The fluorescent material for converting wavelengths as set forth in the item (1) or (2), wherein the fluorescent substance is a europium complex.

(4) A resin composition for converting wavelengths comprising the fluorescent material for converting wavelengths as set forth in any one of the items (1) to (3), mixed in a transparent dispersion medium resin,
   wherein the vinyl compound is polymerized before the fluorescent material for converting wavelengths is mixed with the transparent dispersion medium resin,

(5) The resin composition for converting wavelengths as set forth in the item (4), wherein the fluorescent material for converting wavelengths is mixed in an amount of 0.00001.% to 1% by mass, in terms of the mass concentration of the fluorescent substance, relative to the total amount of non-volatile components.

(6) A solar cell module, using the resin composition for converting wavelengths as set forth in the item (4) or (5), as at least one layer of light transmitting layers.

(7) A method for producing the resin composition for converting wavelengths as set forth in the item (4) or (5), comprising the steps of:
   mixing a fluorescent substance and an acrylic monomer and/or a methacrylic monomer to obtain a fluorescent material for converting wavelengths;
   polymerizing the acrylic monomer and/or methacrylic monomer of the fluorescent material for converting wavelengths to obtain a fluorescent material for converting wavelengths after polymerization; and
   mixing the fluorescent material for converting wavelengths after polymerization, with a transparent dispersion medium resin to obtain the resin composition for converting wavelengths.

(8) A method for producing a solar cell module, comprising the step of:
   forming the resin composition for converting wavelengths as set forth in the item (4) or (5) into a sheet form, and allowing the sheet to constitute at least one layer of the light transmitting layers of a solar cell module.

(9) A method for producing a solar cell module, comprising the step of:
   forming the resin composition for converting wavelengths as set forth in the item (4) or (5) into a film form, pasting the film to the inner side of a photovoltaic cell or a protective glass, and allowing the film to constitute at least one layer of the light transmitting layers of a solar cell module.

### ADVANTAGEOUS EFFECTS OF INVENTION

According to the present invention, there can be provided a fluorescent material for converting wavelengths capable of converting a light in a wavelength region that contributes less to solar energy generation in the incident solar radiation, to a light in a wavelength region that contributes significantly to energy generation, as well as capable of utilizing solar radiation efficiently and stably without scattering of the solar radiation when applied to a solar cell module; a resin composition for converting wavelengths; and a method for producing the resin composition. Furthermore, a solar cell module can also be provided, which can utilize solar radiation efficiently and stably by using these fluorescent material and resin composition.

The disclosure of the present application is related to the subject matter described in Japanese Patent Application No. 2009-224517 filed on September 29, 2009, the disclosure of which is incorporated herein by reference.

### DESCRIPTION OF EMBODIMENTS

### <Fluorescent material for converting wavelengths>

The fluorescent material for converting wavelengths of the present invention is a material obtainable by mixing a fluorescent substance and a vinyl compound, and is characterized by being used in a light transmitting layer of a solar cell module.

Among fluorescent substances, the organic complex of a rare earth metal that is used with preference in the present invention is generally deteriorated by an acid, an alkali or moisture, and has a problem that the wavelength conversion efficiency deteriorates over time. For that reason, when the fluorescent substance is mixed into a vinyl compound, the vinyl compound blocks an acid, an alkali or moisture, thereby enhancing moisture resistance and dispersibility, and thus, an effect of preventing the deterioration of the wavelength conversion efficiency of the fluorescent substance is obtained.

In the fluorescent material for converting wavelengths, as the fluorescent substance (an organic complex of a rare earth metal that is used with preference) is mixed into a vinyl compound, scattering of light is suppressed.

Meanwhile, by "mixing a fluorescent substance into a vinyl compound" in the present invention, the fluorescent substance is dissolved or dispersed into the vinyl compound. Even in the case of being dispersed, once the fluorescent substance according to the present invention achieves a dissolved state in the vinyl compound, the fluorescent material for converting wavelengths obtainable thereby achieves a satisfactory dispersed state in a transparent dispersion medium resin.

The dissolved state specifically means the "state in which when the fluorescent substance is mixed with the vinyl compound, particles cannot be recognized by visual inspection."

Furthermore, as the fluorescent material for converting wavelengths of the present invention is mixed into a transparent dispersion medium resin, the mixture is used as a resin composition for converting wavelengths. However, in the resin composition for converting wavelengths, the fluorescent material for converting wavelengths is in a satisfactory dispersed state in the transparent dispersion medium resin. The details will be described later.

The fluorescent material for converting wavelengths contains a fluorescent substance and a vinyl compound as components. Further, the fluorescent material for converting wavelengths may optionally contain a radical polymerization initiator such as a peroxide and the like.

Hereinafter, the components used in the fluorescent material for converting wavelengths will be explained.

### (Fluorescent substance)

Examples of the fluorescent substance used in the present invention include organic complexes of rare earth metals, but among others, a europium complex and a samarium complex are preferred.. Specifically, europium (Eu) as the central element as well as molecules that serve as ligands are needed; however, in the present invention, the ligand is not intended to be limited, and any molecule that can form a complex with europium or samarium may be used.

As an example of fluorescent substance particles formed from such a europium complex, a rare earth metal complex, for example, Eu(TTA)₃phen can be used. In regard to the method for producing Eu(TTA)₃Phen, reference can be made to, for example, the method disclosed in Masaya Mitsuishi, Shinji Kikuchi, Tokuji Miyashita, Yutaka. Amano, J. Mater. Chem. 2003, 13, 285-2879.

In the present invention, the ligand is not limited, but preferred examples of a neutral ligand include a carboxylic acid, a nitrogen-containing organic compound, a nitrogen-containing aromatic heterocyclic compound, a β-diketone, and a phosphine oxide.

As a ligand for the rare earth metal complex, a β-diketone may be contained, which is represented by the formula: R¹COCHR²COR³ (wherein R¹ represents an aryl group, an alkyl group, a cycloalkyl group, a cycloalkylalkyl group, an aralkyl group, or a substituent thereof; R² represents H, an alkyl group, a cycloalkyl group, a cycloalkylalkyl group, an aralkyl group or an aryl group; and R³ represents an aryl group, an alkyl group, a cycloalkyl group, a cycloalkylalkyl group, an aralkyl group or a substituent thereof).

Specific examples of the β-diketone include acetylacetone, perfluoroacetylacetone, benzoyl-2-furanoylinethane, 1,3-bis(3-pyridyl)-1,3-propanedione, benzoyltrifluoroacetone, benzoylacetone, 5-chlorosulfonyl-2-tenoyltrifluoroacetone, di(4-bromo)benzoylmethane, dibenzoylmethane, d,d-dicamphorylmethane, 1,3-dicyano-1,3-propanedione, p-di(4,4,5,5,6,6,6-heptafluoro-1,3-hexanedinoyl)benzene, 4,4'-dimethoxydibenzoylmethane, 2,6-dimethyl-3,5-heptanedione, dinaphthoylmethane, dipivaloylmethane, di(perfluoro-2-propoxypropionyl)methane, 1,3-di(2-thienyl)-1,3-propanedione, 3-(trifluoroacetyl)-d-camphor, 6,6,6-trifluoro-2,2-dimethyl-3,5-hexanedione, 1,1,1,2,2,6,6,7,7,7-decafluoro-3,5-heptanediane, 6,6,7,7,8,8,8-heptafluoro-2,2-dimethyl-3,5-octanedione, 2-furyltrifluoroacetone, hexafluoroacetylacetone, 3-(heptafluorobutyryl)-d-camphor, 4,4,5,5,6,6,6-heptafluoro-1-(2-thienyl)-1,3-hexanedione, 4-methoxydibenzoylmethane, 4-methoxybenzoyl-2-furanoylmethane, 6-methyl-2,4-heptanedione, 2-naphthoyltrifluoroacetone, 2-(2-pyridyl)benzimidazole, 5,6-dihydroxy-10-phenanthroline, 1-phenyl-3-methyl-4-benzoyl-5-pyrazole, 1-phenyl-3-methyl-4-(4-butylbenzoyl)-5-pyrazole, 1-phenyl-3-methyl-4-isobutyryl-5-pyrazole, 1-phenyl-3-methyl-4-trifluoroacetyl-5-pyrazole, 3-(5-phenyl-1,3,4-oxadiazol-2-yl)-2,4-pentanedione, 3-phenyl-2,4-pentanedione, 3-[3',5'-bis(phenylmethoxy)phenyl]-1-(9-phenanthyl)-1-propane-1,3-di one, 5,5-dimethyl-1,1,1-trifluoro-2,4-hexanedione, 1-phenyl-3-(2-thienyl)-1,3-piopanedione, 3-(t-butylhydroxymethylene)-d-camphor, 1,1,1-trifluoro-2,4-pentanedione; 1,1,1,2,2,3,3,7,7,8,8,9,9,9-tetradecafluoro-46-nonanedione, 2,2,6,6-tetramethyl-3,5-heptanedione, 4,4,4-trifluoro-1-(2-naphthyl)-1,3-butanedione, 1,1,1-trifluoro-5,5-dimethyl-2,4-hexanediane, 2,2,6,6-tetramethyl-3,5-heptanedione, 2,2,6,6-tetramethyl-3,5-octanedione, 2,2,6-trimethyl-3 ,5-heptanedione, 2,2,7-trimethyl-3 ,5-octanedione, 4,4,4-trifluoro-1-(thienyl)-1,3-butanedione (TTA), 1,3-diphenyl-1,3-propanedione, benzoylacetone, dibenzoylacetone, diisobutyroylmethane, dipivaloylmethane, 3-methylpentane-2,4-dione, 2,2-dimethylpentane-3,5-dione, 2-methyl-1,3-butanedione, 1,3-butanedione, 3-phenyl-2,4-pentanedione, 1,1,1 trifluoro-2,4-pentanedione, 1,1,1-trifluoro-5,5-dimethyl-2,4-hexanedione, 2,2,6,6-tetramethyl-3,5-heptanedione, 3-methyl-2,4-pentanedione, 2-acetylcyclopentanone, 2-acetylcyclohexanone, 1-heptafluoropropyl-3-t-butyl-1,3-propanedione, 1,3-diphenyl-2-methyl-1,3-propanedione, 1-ethoxy-1,3-butanedione and the like.

Examples of the nitrogen-containing organic compound, nitrogen-containing aromatic heterocyclic compound and phosphine oxide as the neutral ligand of the rare earth metal complex include 1,10-phenanthroline, 2,2'-bipyridyl, 2,2'-6,2"-terpyridyl, 4,7-diphenyl-1,10-phenanthroline, 2-(2-pyridyl)benzimidazole, triphenylphosphine oxide, tri-n-butylphosphine oxide, tri-n-octylphosphine oxide, tri-n-butyl phosphate, and the like.

Particularly, when a europium complex is used as the fluorescent substance, a solar cell module having high energy generation efficiency can be realized. A europium complex converts a light in the ultraviolet region to a light in the red wavelength region with high wavelength conversion efficiency, and this converted light contributes to the energy generation in a photovoltaic cell.

### (Vinyl compound)

The vinyl compound as used in the present invention is not particularly limited as long as it is an acrylic monomer, a methacrylic monomer, an acrylic oligomer, a methacrylic oligomer or the like, which can form a vinyl resin, particularly an acrylic resin or a methacrylic resin, when subjected to a polymerization reaction. Preferred examples include an acrylic monomer and a methacrylic monomer.

Examples of the acrylic monomer and methacrylic monomer include acrylic acid, methacrylic acid, and alkyl esters thereof. Furthermore, other vinyl monomers that are copolymerizable with these monomers may also be used in combination, and the monomers can be used singly or in combination of two or more kinds.

Examples of the acrylic acid alkyl ester or methacrylic acid alkyl ester include acrylic acid unsubstituted alkyl esters or methacrylic acid unsubstituted alkyl esters such as methyl acrylate, methyl methacrylate, ethyl acrylate, ethyl methacrylate, butyl acrylate, butyl methacrylate, 2-ethylhexyl acrylate, and 2-ethylhexyl methacrylate;
dicyclopentenyl (meth)acrylate;
tetrahydrofurfuryl (meth)acrylate;
a compound obtainable by allowing a polyhydric alcohol to react with an α,β-unsaturated carboxylic acid (for example, polyethylene glycol di(meth)acrylate (having a number of ethylene groups of 2 to 14), trimethylolpropane di(meth)acrylate, trimethylolpropane tri(meth)acrylate, trimethylolpropane ethoxytri(meth)acrylate, trimethylolpropane propoxytri(meth)acrylate, tetramethylolmethane tri(meth)acrylate, tetramethylolmethane tetra(meth)acrylate, polypropylene glycol di(meth)acrylate (having a number of propylene groups of 2 to 14), dipentaerythritol penta(meth)acrylate, dipentaerythritol hexa(meth)acrylate, bisphenol A polyoxyethylene di(meth)acrylate, bisphenol A dioxyethylene di(meth)acrylate, bisphenol A trioxyethylene di(meth)acrylate, or bisphenol A decaoxyethylene di(meth)acrylate);
a compound obtainable by adding an α,β-unsaturated carboxylic acid to a glycidyl group-containing compound (for example, trimethylolpropane triglycidyl ether triacrylate, or bisphenol A diglycidyl ether diacrylate);
an esterification product of a polyvalent carboxylic acid (for example, phthalic anhydride) and a substance having a hydroxyl group and an ethylenically unsaturated group (for example, β-hydroxyethyl (meth)acrylate);
urethane (meth)acrylate (for example, a reaction product between tolylene diisocyanate and a 2-hydroxyethyl (meth)acrylic acid ester, or a reaction product between trimethylhexamethylene diisocyanate and cyclohexanedimethanol and a 2-hydroxyethyl(meth)acrylic acid ester); and
an acrylic acid substituted alkyl ester or a methacrylic acid substituted alkyl ester having its alkyl group substituted with a hydroxyl group, a.n epoxy group, a halogen group or the like.

Furthermore, examples of the other vinyl monomers that are copolymerizable with acrylic acid, methacrylic acid, an acrylic acid alkyl ester or a methacrylic acid alkyl ester, include acrylamide, acrylonitrile, diacetone acrylamide, styrene, vinyltoluene, and the like. These vinyl monomers can be used singly or in combination of two or more kinds.

For the acrylic oligomer and methacrylic oligomer, those produced by polymerizing the acrylic monomers and methacrylic monomers described above are used.

### (Radical polymerization initiator)

Examples of the radical polymerization initiator intended for the polymerization of the vinyl compound may be peroxides. Specifically, an organic peroxide which generates a free radical under the action of heat is preferred, and examples thereof that can be used include isobutyl peroxide, α,α'-bis(neodecanoylperoxy)diisopropylbenzene, cumyl peroxyneodecanoate, di-n-propyl peroxydicarbonate, di-s-butyl peroxydicarbonate, 1,1,3,3-tetramethylbutyl neodecanoate, bis(4-t-butylcyclohexyl) peroxydicarbonate, 1-cyclohexyl-1-methytethyl peroxyneodecaaaoate, di-2-ethoxyethyl peroxydicarbonate, di(ethylhexylperoxy) dicarbonate, t-hexyl neodecanoate, dimethoxybutyl peroxydicarbonate, di(3-methyl-3-methoxybutylperoxy) dicarbonate, t-butyl peroxyneodecanoate, t-hexyl peroxypivalate, 3,5,5-trimethylhexanoyl peroxide, octanoyl peroxide, lauroyl peroxide, stearoyl peroxide, 1,1,3,3-tetramethylbutyl peroxy-2-ethylhexanoate, succinic peroxide, 2,5-dimethyl-2,5-di(2-ethylhexanoyl)hexane, 1-cyclohexyl-1-methylethyl peroxy-2-ethylhexanoate, t-hexyl peroxy-2-ethylhexanoate, 4-methylbenzoyl peroxide, t-butyl peroxy-2-ethylhexanoate, m-toluonoylbenzoyl peroxide, benzoyl peroxide, t-butyl peroxyisobutyrate, 1,1-bis(t-butylperoxy)-2-methylcyclohexane, 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane; 1,1 -bis(t-butylperoxy)cyclohexanone, 2,2-bis(4,4-dibutylperoxycyclohexyl)propane, 1,1-bis(t-butylperoxy)cyclododecane, t-hexyl peroxyisopropyl monocarbonate, t-butylperoxymaleic acid, t-butyl peroxy-3,5,5-trimethylhexanoate, t-butyl peroxylaurate, 2,5-dimethyl-2,5-di(m-toluoylperoxy)hexane, t-butyl peroxyisopropyl monocarbonate, t-butyl peroxy-2-ethylhexyl monocarbonate, t-hexyl peroxybenzoate, 2,5-dimethyl-2,5-di(benzoylperoxy)hexane, t-butyl peroxyacetate, 2,2-bis(t-butylperoxy)butane, t-butyl peroxybenzoate, n-butyl 4,4-bis(t-butylperoxy)valerate, di-t-butyl peroxyisophthalate, α,α'-bis(t-butylperoxy)diisopropylbenzene, dicumyl peroxide, 2,5-dimethyl-2,5-di(t-butylperoxy)hexane, t-butyl cumyl peroxide, di-t-butylperoxy-, p-methane hydroperoxide, 2,5-dimethyl-2,5-di(t-butylperoxy)hexyne, diisopropylbenzene hydroperoxide, t-butyltrimethylsilyl peroxide, 1,1,3,3-tetramethylbutyl hydroperoxide, cumene hydroperoxide, t-hexyl hydroperoxide, t-butyl hydroperoxide, 2,3-dimethyl-2,3-diphenylbutane, and the like.

### (Method for producing fluorescent material for converting wavelengths)

The fluorescent material for converting wavelengths of the present invention is obtained by mixing the fluorescent substance and vinyl compound described above, and optionally a radical polymerization initiator such as a peroxide and the like, and dissolving or dispersing the fluorescent substance in the vinyl compound. The method of mixing is not particularly limited, and for example, mixing may be carried out by stirring.

A preferred content of the fluorescent substance may be within the range of 0.001 % to 1.0% by mass in the vinyl compound. A more preferred content is within the range of 0.01 % to 0.5% by mass. When the fluorescent substance is contained in this range, a dissolved state is achieved.

Furthermore, while the fluorescent material for converting wavelengths of the present invention means a product obtained after the polymerization of the vinyl compound, a product before polymerization is also included in the scope of the present invention.

The vinyl compound is appropriately selected such that when the fluorescent material for converting wavelengths after polymerization is mixed into a transparent dispersion medium resin, the fluorescent material for converting wavelengths has good dispersibility in the transparent dispersion medium resin.

Specifically, a state with good dispersibility refers to a state in which scattering that causes light loss in the wavelength conversion layer does not occur or has been minimized, In order to achieve a state with less light scattering as such, the state can be achieved by the following method.

For the resin composition of the fluorescent material for converting wavelengths (vinyl compound described above) and the transparent dispersion medium resin composition, compositions that are mutually well dispersible are selected.

In the rare earth metal complex in the fluorescent substance, precipitation of the fluorescent substance in the vinyl compound can be avoided and a satisfactory mixed state (preferably, a dissolved state) can be obtained, by changing the ligand. Meanwhile, the solubility parameter can provide an indicator of a satisfactory mixed state.

Even if precipitation of the fluorescent substance has occurred in the fluorescent material for converting wavelengths before and after polymerization, the problem may be solved by appropriately selecting the method for the polymerization of the fluorescent material for converting wavelengths. For example, the polymerization methods include suspension polymerization and emulsion polymerization. Furthermore, light scattering can be reduced by lowering the concentration of the substance that is causative of light scattering. For example, if the precipitation of the fluorescent substance is causative of light scattering, the concentration of the fluorescent substance in the fluorescent material for converting wavelengths may be decreased. If the fluorescent material for converting wavelengths in the transparent dispersion medium resin is causative of light scattering, the concentration of this material may be decreased.

### <Resin composition for converting wavelengths>

The fluorescent material for converting wavelengths of the present invention can be prepared into a resin composition for converting wavelengths by mixing the fluorescent material into a transparent dispersion medium resin after the vinyl compound is polymerized.

A preferred incorporation amount of the fluorescent material for converting wavelengths in the resin composition for converting wavelengths of the present invention is preferably within the range of 0.00001 % to 1% by mass, in terms of the mass concentration of the organic complex of a rare earth metal (preferably, a europium complex), relative to the total amount of non-volatile components. If the incorporation amount is 0.00001% by mass or less, the light emission efficiency tends to be low. If the incorporation amount is I % by mass or more, there is a tendency that the light emission efficiency decreases due to concentration quenching, or scattering of the incident light may exert adverse influence on the effect of energy generation.

### (Transparent dispersion medium resin)

As the transparent dispersion medium resin in the resin composition for converting wavelengths of the present invention, a photocurable resin, a thermosetting resin, a thermoplastic resin and the like are used with preference.

As the resin that has been traditionally used as a sealing agent resin for solar cells, ethylene-vinyl acetate copolymers (also referred to as "EVA") imparted with thermosettability are widely used from the viewpoints of cost and transparency, as disclosed in Patent Literatures 18 to 25 described above. Therefore, it is preferable that the transparent dispersion medium resin according to the present invention contain an EVA.

However, the present invention is not intended to be limited to a transparent sealing resin which also serves as a dispersion medium, and a thermoplastic resin, a thermosetting resin and a photocurable resin can all be used.

When a photocurable resin is used as the transparent dispersion medium resin, there are no particular limitations on the resin constitution of the photocurable resin or on the photocuring method. For example, in a photocuring method based on a photoradical polymerization initiator, the resin composition for converting wavelengths contains, in addition to the fluorescent material for converting wavelengths, (A) a binder resin, (B) a. crosslinkable monomer, (C) a photopolymerization initiator that produces a free radical under the action of light or heat, and the like.

Here, examples of the (A) binder resin that may be used include homopolymers having acrylic acid, methacrylic acid or an alkyl ester thereof as a constituent monomer, and copolymers formed by copolymerizing these monomers and other vinyl monomers that are copolymerizable with the foregoing monomers as constituent monomers.

These copolymers can be used singly, or two or more kinds can also be used in combination. Use can be made of homopolymers and copolymers composed of one kind or plural kinds of an acrylic acid alkyl ester and a methacrylic acid alkyl ester, for example, an acrylic acid unsubstituted alkyl ester or a methacrylic acid unsubstituted alkyl ester such as methyl acrylate, methyl methacrylate, ethyl acrylate, ethyl methacrylate, butyl acrylate, butyl methacrylate, 2-ethylhexyl acrylate, and 2-ethylhexyl methacrylate; or
an acrylic acid substituted alkyl ester or a methacrylic acid substituted alkyl ester, having their alkyl groups substituted with a hydroxyl group, an epoxy group, a halogen group or the like.

Furthermore, examples of the other vinyl monomer that are copolymerizable with acrylic acid, methacrylic acid, an acrylic acid alkyl ester or a methacrylic acid alkyl ester, include acrylamide, acrylonitrile, diacetoneacrylamide, styrene, vinyltoluene, and the like. These vinyl monomers can be used singly or in combination of two or more kinds. Furthermore, the weight average molecular weight of the dispersion medium resin of the component (A) is preferably within the range of 10,000 to 300,000, in view of film-formability and film strength.

Examples of the (B) crosslinkable monomer include dicyclopentenyl (meth)acrylate; tetrahydrofurfuryl (meth)acrylate;
benzyl (meth)actylate; a compound obtainable by allowing a polyhydric alcohol to react with an α,β-unsaturated carboxylic acid (for example, polyethylene glycol di(meth)acrylate (having a number of ethylene group of 2 to 14), trimethylolpropane di(meth)acrylate, trimethylolpropane tri(meth)acryla.te, trimethylolpropane ethoxytri(meth)acrylate, trimethylolpropane propoxytri(meth)acrylate, tetramethylolmethane tri(meth)acrylate, tetramethylolmethane tetra(meth)acrylate, polypropylene glycol di(meth)acrylate (having a number of propylene groups of 2 to 14), dipentaerythritol penta(meth)acrylate, dipentaerythritol hexa(meth)acrylate, bisphenol A polyoxyethylene di(meth)acrylate, bisphenol A dioxyethylene di(meth)acrylate, bisphenol A trioxyethylene di(meth)acrylate, bisphenol A decaoxyethylene di(meth)acrylate, or the like);
a compound obtainable by adding an α,β-unsaturated carboxylic acid to a glycidyl group-containing compound (for example, trimethylolpropane triglycidyl ether triacrylate, bisphenol A diglycidyl ether diacrylate, or the like);
an esterification product of a polyvalent carboxylic acid (for example, phthalic anhydride) and a substance having a hydroxyl group and an ethylenically unsaturated group (for example, β-hydroxyethyl (meth)acrylate);
an alkyl ester of acrylic acid or methacrylic acid (for example, (meth)acrylic acid methyl ester, (meth)acrylic acid ethyl ester, (meth)acrylic acid butyl ester, or (meth)acrylic acid 2-ethylhexyl ester);
a urethane (meth)acrylate (for example, a reaction product between tolylene diisocyanate and 2-hydroxyethyl (meth)acrylic acid ester, or a reaction product between trimethylhexamethylene diisocyanate, cyclohexanedimethanol and 2-hdyroxyethyl (meth)acrylic acid ester); and the like.

Particularly preferred examples of the (B) crosslinkable monomer include trimethylolpropane tri(meth)acrylate, dipentaerythritol tetra(meth)acrylate, dipentaerythritol hexa(meth)acrylate, and bisphenol A polyoxyethylene dimethacrylate, from the viewpoint of the crosslinking density, or easy controllability of the reactivity. The compounds described above are used singly or in combination of two or more kinds.

Particularly, in the case of setting the refractive index of the resin composition for converting wavelengths high, it is advantageous that the (A) binder resin and/or (B) crosslinkable monomer contain a bromine atom or a sulfur atom. Examples of bromine-containing monomers include NEW FRONTIER BR-31, NEW FRONTIER BR-30, NEW FRONTIER BR-42M manufactured by Daiichi Kogyo Co., Ltd., and the like. Examples of sulfur-containing monomer compositions include IU-L2000, IU-L,3000, and IU-MS1010 manufactured by Mitsubishi Gas Chemical Co., Inc. The bromine atom-containing monomers or the sulfur atom-containing monomers (polymers containing them) used in the present invention are not intended to be limited to those mentioned herein.

As the (C) photopolymerization initiator, a photopolymerization initiator that produces a free radical under the action of ultraviolet radiation or visible light is preferred, and examples thereof include benzoin ethers such as benzoin methyl ether, benzoin methyl ether, benzoin propyl ether, benzoin isobutyl ether, and benzoin phenyl ether;
benzophenones such as benzophenone, N,N'-tetramethyl-4,4'-diaminobenzophenone (Michler's ketone), N,N'-tetraethyl-4,4'-diaminobenzophenone;
benzyl ketals such as benzyl dimethyl ketal (IRGACURE 651 manufactured by Ciba Specialty Chemical, Inc.), and benzyl diethyl metal;
acetophenones such as 2,2-dimethoxy-2-phenylacetophenone, p-tert-butyldichloroacetophenone, and p-dimethylaminoacetophenone;
xanthones such as 2,4-dimethylthioxanthone, and 2,4-diisopropylthioxanthone; and
hydroxycyclohexyl phenyl ketone (IRGACURE 184 manufactured by Ciba Specialty Chemicals, Inc.), 1-(4-isopropylphenyl)-2-hydroxy-2-methylpropan-1-one (DAROCURE 1116 manufactured by Merck GmbH), and 2-hydroxy-2-methyl-1-phenylpropan-1-one (DAROCURE 1173 manufactured by Merck GmbH). These are used singly or in combination of two or more kinds.

Further examples of photopolymerization initiators that can be used as the (C) photopolymerization initiator include combinations of a 2,4,5-triallylimidazole dimer with 2-mercaptobenzoxazole, leuco crystal violet, or tris(4-diethylamino-2-methylphenyl)methane. Furthermore, an additive which itself does not have photoinitiation capability, but constitutes a sensitizer system having more satisfactory photoinitiation performance in toto when used in combination with the substances mentioned above, for example, a tertiary amine such as triethanolamine in conjunction with benzophenone, can be used.

Furthermore, in order to make the system thermosettable, the (C) photopolymerization initiator may be changed to a thermal polymerization initiator.

As the (C) thermal polymerization initiator, an organic peroxide which produces a free radical under the action of heat is preferred, and examples thereof that can be used include isobutyl peroxide, α,α'-bis(neodecanoylperoxy)diisopropylbenzene, cumyl peroxyneodecanoate, di-n-propyl peroxydicarbonate, di-s-butyl peroxydicarbonate, 1,1,3,3-tetramethylbutyl neodecanoate, bis(4-t-butylcyclohexyl) peroxydicarbonate, 1-cyclohexyl-1-methylethyl peroxyneodecanoate, di-2-ethoxyethyl peroxydicarbonate, di(ethylhexylperoxy) dicarbonate, t-hexyl neodecanoate, dimethoxybutyl peroxydicarbonate, di(3-methyl-3-methoxybutylperoxy) dicarbonate, t-butyl peroxyneodecanoate, t-hexyl peroxypivalate, 3,5,5-trimethylhexanoyl peroxide, octanoyl peroxide, lauroyl peroxide, stearoyl peroxide, 1,1,3,3-tetramethylbutyl peroxy-2-ethylhexanoate, succinic peroxide, 2,5-dimethyl-2,5-di(2-ethylhexanoyl)hexane, 1-cyclohexyl-1-methylethyl peroxy-2-ethylhexanoate, t-hexyl peroxy-2-ethylhexanoate, 4-methylbenzoyl peroxide, t-butyl peroxy-2-ethylhexanoate, m-toluonoylbenzoyl peroxide, benzoyl peroxide, t-butyl peroxyisobutyrate,
1,1-bis(t-butylperoxy)-2-methylcyclohexane, 1,1-bis(t-hexylperoxy)-3,3,5-trimethylcyclohexane,
1,1-bis(t-hexylperoxy)cyclohexane, 1,1-bis(t-butylperoxy)-3,3,5-trimethylcyclohexane, 1,1-bis(t-butylperoxy)cyclohexanone, 2,2-bis(4,4-dibutylperoxycyclohexyl)propane, 1,1-bis(t-butylperoxy)cyclododecane, t-hexyl peroxyisopropyl monocarbonate, t-butylperoxymaleic acid, t-butyl peroxy-3,5,5-trimethylhexanoate, t-butyl peroxylaurate,
2,5-dimethyl-2,5-di(m-toluoylperoxy)hexane, t-butyl peroxyisopropyl monocarbonate, t-butyl peroxy-2-ethylhexyl monocarbonate, t-hexyl peroxybenzoate, 2,5-dimethyl-2,5-di(benzoylperoxy)hexane, t-butyl peroxyacetate, 2,2-bis(t-butylperoxy)butane, t-butyl peroxybenzoate, n-butyl 4,4-bis(t-butylperoxy)valerate, di-t-butyl peroxyisophthalate, α,α'-bis(t-butylperoxy)diisopropylbenzene, dicumyl peroxide, 2,5-dimethyl-2,5-di(t-butylperoxy)hexane, t-butyl cumyl peroxide, di-t-butylperoxy-,p-menthane hydroperoxide, 2,5-dimethyl-2,5-di(t-butylperoxy)hexyne, diisopropylbenzene hydroperoxide, t-butyltrimethylsilyl peroxide, 1,1,3,3-tetramethylbutyl hydroperoxide, cumene hydroperoxide, t-hexyl hydroperoxide, t-butyl hydroperoxide, 2,3-dimethyl-2,3-diphenylbutane, and the like.

In the case of using a thermoplastic resin that is fluidized when heated or pressurized, as the transparent dispersion medium resin of the resin composition for converting wavelengths, for example, polyolefins such as polyethylene, polypropylene, polyisobutene, and polybutene;
(di)enes such as polyisoprene, poly-1,2-butadiene, poly-2-heptyl-1,3-butadiene, poly-2-t-butyl-1,3-butadiene, and poly-1,3-butadiene;
polyethers such as polyoxyethylene, polyoxypropylene, polyvinyl ethyl ether, polyvinyl hexyl ether, and polyvinyl butyl ether;
polyvinyl such as polyvinyl acetate, and polyvinyl chloride;
polyesters such as polyvinyl acetate and polyvinyl propionate;
polyacrylics such as polyacrylonitrile, polymethacrylonitrile, polyethyl acrylate, polybutyl acrylate, poly-2-ethylhexyl acrylate, poly-t-butyl acrylate, poly-3-ethoxypropyl acrylate, polyoxycarbonyl tetramethacrylate, polymethyl acrylate, polyisopropyl methacrylate, polydodecyl methacrylate, polytetradecyl methacrylate, poly-n-propyl methacrylate, poly-3,3,5-trimethylcyclohexyl methacrylate, polyethyl methacrylate, poly-2-nitro-2-methylpropyl methacrylate, poly-1,1-diethylpropyl methacrylate, and polymethyl methacrylate; as well as polysulfone; phenoxy resins; natural rubber; ethyl cellulose; and polyurethane can be used as the dispersion medium resin.

These thermoplastic resins are such that two or more kinds may be copolymerized as necessary, or two or more kinds may be used as a blend.

Furthermore, as copolymerized resins with the resins described above, epoxy acrylate, urethane acrylate, polyether acrylate, polyester acrylate and the like can also be used. Particularly, from the viewpoint of adhesiveness, urethane acrylate, epoxy acrylate, and polyether acrylate are excellent.

Examples of epoxy acrylate include (meth)acrylic acid adducts such as 1,6-hexanediol diglycidyl ether, neopentyl glycol diglycidyl ether, allyl alcohol diglycidyl ether, resorcinol diglycidyl ether, adipic acid diglycidyl ester, phthalic acid diglycidyl ester, polyethylene glycol diglycidyl ether, trimethylolpropane triglycidyl ether, glycerin triglycidyl ether, pentaerythritol tetraglycidyl ether, and sorbitol tetraglycidyl ether.

A polymer having a hydroxyl group in the molecule, such as epoxy acrylate, is effective for enhancing adhesiveness. These copolymerized resins can be used in combination of two or more kinds as necessary. The softening temperature of these resins is preferably 150°C or lower, and more preferably 100°C or lower, in view of handleability. When it is considered that the use environment temperature of solar cell units is usually 80°C or lower, and processability is considered, the softening temperature of the resins is particularly preferably within the range of 80°C to 120°C,

The additional constitution of the resin composition for converting wavelengths in the case of using a thermoplastic resin as the transparent dispersion medium resin, is not particularly limited as long as the fluorescent material for converting wavelengths of the present invention is incorporated; however, components that are conventionally used, for example, a plasticizer, a flame retardant, and a stabilizer can be incorporated.

As the transparent medium resin of the resin composition for converting wavelengths of the present invention, there are no particular limitations on the resin, and a photocurable resin, a thermosetting resin, a thermoplastic resin and the like can be used as described above. However, a particularly preferred example of the resin may be a composition obtained by mixing an ethylene-vinyl acetate copolymer that is widely used as a conventional transparent dispersion medium resin for solar cells, with a thermoradical polymerization initiator, and optionally a crosslinking aid, an adhesive aid, an ultraviolet absorber, a stabilizer and the like.

The resin composition for converting wavelengths of the present invention has excellent moisture resistance, as the fluorescent material for converting wavelengths of the present invention is used. A solar radiation can be efficiently introduced into a photovoltaic cell, without any scattering of light, since the fluorescent material for converting wavelengths has satisfactory dispersibility in the transparent dispersion medium resin.

Meanwhile, when it is said that "the fluorescent material for converting wavelengths has satisfactory dispersibility in the transparent dispersion medium resin" in the present invention, it implies a state in which particles or turbidity cannot be recognized by visual inspection when the fluorescent material for converting wavelengths is dispersed and mixed in the transparent dispersion medium resin, and more specifically, it implies a state as described below.

First, the fluorescent material for converting wavelengths is allowed to react so as to polymerize the vinyl compound. The conditions for this reaction are appropriately determined depending on the vinyl compound used.

Thereafter, the polymerized fluorescent material for converting wavelengths is mixed with the transparent dispersion medium resin at a predetermined concentration, a resin composition for converting wavelengths is obtained, and the transparent dispersion medium resin is cured. The conditions for this curing are also appropriately determined depending on the transparent dispersion medium resin used.

The turbidity of the cured resin composition for converting wavelengths is measured using a haze meter (NDH-2000, manufactured by Nippon Denshoku Industries Co., Ltd.), and when the turbidity is 5% or less, it is said that "the fluorescent material for converting wavelengths has satisfactory dispersibility in the transparent dispersion medium resin".

The resin composition for converting wavelengths of the present invention can be used as one light transmitting layer of a solar cell module having plural light transmitting layers.

A solar cell module is composed of essential members such as, for example, an antireflective film, a protective glass, a sealing material, a photovoltaic cell, a back film, cell electrodes, a tab line and the like. Among these members, examples of the light transmitting layer having light transmissibility include an antireflective film, a protective glass, a sealing material, the SiNx:H layer and Si layer of solar cells, and the like.

The resin composition for converting wavelengths of the present invention is preferably used as a sealing material even among the light transmitting layers described above. Furthermore, the resin composition for converting wavelengths can also be disposed as a film for converting wavelengths between a protective glass and a sealing material, or between a sealing material and a photovoltaic cell.

In the case of using the resin composition for converting wavelengths as a light transmitting layer, the transparent dispersion medium resin needs to have refractivity that is at least equivalent to or higher than that of the layers on the incident side.

More specifically, when the plural light transmitting layers are designated as layer 1, layer 2, ..., layer m from the light incidence side, and the refractive indices of these layers are designated as n1, n2, ..., nm, it is preferable that the relation: n1 ≤ n2 ≤ ... ≤ nm be established.

According to the present invention, the order of lamination of the light transmitting layers mentioned above is usually such that an antireflective film, a protective glass, a sealing material and the SiNx:H layer and Si layer of a photovoltaic cell, which are formed according to necessity, are laminated in this order from the light-receiving surface of the solar cell module.

That is, when the resin composition for converting wavelengths of the present invention is used as a sealing material, in order to make external light that enters from every angle to be introduced efficiently into a photovoltaic cell with less reflection loss, it is preferable that the refractive index of the resin composition for converting wavelengths be higher than the refractive indices of the light transmitting layers disposed closer to the light incidence side than the resin composition for converting wavelengths, that is, an antireflective film, a protective glass and the like, and be lower than the refractive indices of the light transmitting layers that are disposed closer to the counter-light incidence side of the sealing material formed from the resin composition for converting wavelengths of the present invention, that is, the SiNx:H layer (also called a "cell antireflective film") and the Si layer of a photovoltaic cell.

When the resin composition for converting wavelengths of the present invention is used as a sealing material, the sealing material is disposed on the light-receiving surface of the photovoltaic cell.
In this manner, the resin composition can conform to the concavo-convex shape contained in the textured structure of the light-receiving surface of the photovoltaic cell, cell electrodes, tab lines and the like, without any voids.

In all cases, the resin composition for converting wavelengths contains the fluorescent material for converting wavelengths of the present invention containing a fluorescent substance, preferably a fluorescent material for converting wavelengths using a europium complex as the fluorescent substance, for the purpose of wavelength conversion.

### <Method for producing resin composition for converting wavelengths>

The resin composition for converting wavelengths of the present invention can be produced by a method comprising the steps of:
a step of mixing a fluorescent substance and a vinyl compound (preferably, an acrylic monomer and/or a methacrylic monomer) to obtain a fluorescent material for converting wavelengths;
a polymerization step of polymerizing the acrylic monomer and/or methacrylic monomer of the fluorescent material for converting wavelengths to obtain a fluorescent material for converting wavelengths after polymerization; and
a step of mixing the fluorescent material for converting wavelengths after polymerization with a transparent dispersion medium resin to obtain a resin composition for converting wavelengths.

### (Step to obtain fluorescent material for converting wavelengths)

The method for producing a fluorescent material for converting wavelengths is as described above, but the fluorescent material for converting wavelengths is obtainable by mixing the fluorescent substance and vinyl compound described above, and optionally a radical polymerization initiator such as a peroxide, or the like. There are no particular limitations on the method of mixing, and for example, the mixing may be carried out by stirring the system with a mix rotor, a magnetic stirrer, or a stirring blade.

### (Polymerization step)

The fluorescent material for converting wavelengths thus obtained is polymerized. The polymerization conditions may vary with the vinyl compound and the radical polymerization initiator used, but the conditions may be appropriately adjusted by making reference to the conventional polymerization conditions. More specifically, the vinyl compound that has been mixed with the fluorescent substance is further mixed with a radical polymerization initiator, and temperature is applied in accordance with the radical polymerization initiator.

In regard to the polymer thus produced, the state can be selected in accordance with the glass transition point thereof. For example, when methyl methacrylate or the like having a high glass transition point is used, a surfactant (for example, polyvinyl alcohol, and the like) is added to water that has been maintained at a predetermined temperature, and the liquid prepared by mixing a fluorescent substance and a radical polymerization initiator is suspended in the water thus prepared, a polymer in a particulate form can be obtained (suspension polymerization). Further, when the system is suspended more finely by using other surfactants, finer particles can be obtained (emulsion polymerization). Furthermore, for example, when butyl acrylate or the like having a glass transition point being lower than room temperature is used, a liquid prepared by mixing a fluorescent substance and a radical polymerization initiator is directly polymerized in a container such as a. flask, and thus a polymer having high viscosity can be obtained. In regard to the radical polymerization initiator, for example, an organic peroxide such as lauroyl peroxide is suitable, and in the case of lauroyl peroxide, it is desirable to perform polymerization at 50°C to 60°C.

### (Step to obtain resin composition for converting wavelengths)

Subsequently, the fluorescent material for converting wavelengths after polymerization is mixed with a transparent dispersion medium resin, and a resin composition for converting wavelengths is obtained. Meanwhile, the fluorescent material for converting wavelengths after the polymerization of the vinyl compound is isolated, after the polymerization process, by washing with water and drying, and then is mixed with the transparent dispersion medium resin.

For the mixing conditions, for example, in the case of mixing the fluorescent material with an ethylene-vinyl acetate copolymer, a roll mill can be used. The resin composition for converting wavelengths is obtainable by introducing an ethylene-vinyl acetate copolymer in a pellet form or a powder form, as well as the polymerized fluorescent material for converting wavelengths as described above, a radical polymerization initiator, a silane coupling agent, and other additives into a roll mill that has been adjusted to 90°C, and kneading the mixture.

The resin composition for converting wavelengths of the present invention obtained as described above can be used as a light transmitting layer of a solar cell module. There are no particular limitations on the form of the resin composition for converting wavelengths, but it is preferable to form the resin composition into a sheet form, from the viewpoint of the ease of use. In order to form the resin composition into a sheet form, the sheet can be formed by a press machine that has been adjusted to 90°C, by means of a spacer. When the thickness of the spacer is adjusted to about 0.4 to 1.0 mm, a sheet-like resin composition for converting wavelengths that is easy to use may be obtained.

The resin composition for converting wavelengths obtained as described above can constitute at least one layer of the light transmitting layers of a solar cell module, when the resin composition is formed into a cast film form and is adhered on the inner side of the photovoltaic cell or the protective glass.

The resin composition for converting wavelengths that is intended to be used as a cast film is obtainable by appropriately incorporating a crosslinkable monomer and a photo or thermal polymerization initiator into an acrylic resin polymerized in a solution of toluene or the like, and mixing this with the fluorescent material for converting wavelengths.

This liquid mixture of the resin composition for converting wavelengths is applied on a film that serves as a substrate (for example, a PET film) using an applicator or the like, and the solvent is dried to obtain a cast film.

### <Solar cell module and method for producing the same>

The present invention also includes a solar cell module using the resin composition for converting wavelengths in the scope.

As described above, the resin composition for converting wavelengths of the present invention is used as one of the light transmitting layers of a solar cell module having plural light transmitting layers and a photovoltaic cell.

When a europium complex is used as the fluorescent substance used in the resin composition for converting wavelengths of the present invention, a solar cell module having high energy generation efficiency can be realized. A europium complex converts a light in the ultraviolet region to a light in the red wavelength region with high wavelength conversion efficiency, and this converted light contributes to energy generation in a photovoltaic cell.

A solar cell module can be produced by using a sheet-like resin composition layer obtainable by using the resin composition for converting wavelengths of the present invention, for example, as a sealing material for converting wavelengths between the photovoltaic cell and the protective glass.

Specifically, the method is completely indifferent from a method for producing a silicon crystal solar cell module, except that a layer formed from the resin composition for converting wavelengths of the present invention (particularly preferably, a sheet form) is used, instead of a conventional sealing material sheet. In general, in a silicon crystal solar cell module, first, a sheet-like sealing material (frequently, a product obtained by thermosetting an ethylene-vinyl acetate copolymer with a thermoradical polymerization initiator) is mounted on a cover glass which is a light-receiving surface.
In the present invention, the resin composition for converting wavelengths of the present invention is used as the sealing material used herein. Next, a cell connected with a tab line is mounted thereon, and a sheet-like seating material is further mounted thereon (however, in the present invention, the resin composition for converting wavelengths may be used only on the light-receiving surface side, and for the opposite surface, a conventional sealing material may be used). A back sheet is further mounted thereon, and the assembly is processed into a module using a vacuum press laminator for exclusive use for solar cell modules.

At this time, the hot plate temperature of the laminator is set to a temperature required for the sealing material to soften, melt, encapsulate the cell, and cure, and the sealing material is designed so as to undergo these physical changes and chemical changes usually at 120°C to 180°C, and frequently at 140°C to 160°C.

In the resin composition for converting wavelengths of the present invention, a state prior to being processed into a solar cell module is a semi-cured state, specifically in the case of using a curable resin. Meanwhile, the difference between the refractive index of a layer formed from the resin composition for converting wavelengths in a semi-cured state and the refractive index of a layer after cured (after processed into a solar cell module) is not very large.

There are no particular limitations on the form of the resin composition for converting wavelengths of the present invention, but the resin composition is preferably in a sheet form, from the viewpoint of the ease of production of solar cell modules.

In the case of using the resin composition for converting wavelengths in a cast film form, first, the cast film is laminated on the counter-light incidence surface of the protective glass or on the light incidence surface of the photovoltaic cell using a vacuum laminator, and the substrate film is removed. If the resin composition is photocurable, the resin composition is cured by light irradiation. If the resin composition is thermosetting, the resin composition is cured by applying heat, but it is also possible to simultaneously cure the resin composition by applying heat at the time of lamination. The subsequent processes are completely indifferent from a conventional method for producing a solar cell module.

Meanwhile, the present invention is an improvement of the wavelength conversion type solar cell sealing material of the invention described in Japanese Patent Application No. 2009-157755 filed on July 2, 2009, and has a new effect of moisture resistance.

### EXAMPLE 1

Hereinafter, the present invention will be described more specifically by way of Examples, but the present invention is not intended to be limited to these Examples.

### (Example 1)

### <Synthesis of fluorescent substance>

First, a fluorescent substance is synthesized. 200 mg of 4,4,4-trifluoro-1-(thienyl)-1,3-butanedione (TTA) was dissolved in 7 ml of ethanol, and 1.1 ml of a a 1M sodium hydroxide solution was added thereto and mixed. 6.2 mg of 1,10-phenanthroline dissolved in 7 ml of ethanol was added to the foregoing mixed solution, and the resulting mixture was stirred for one hour. Subsequently, 3.5 ml of an aqueous solution of 103 mg of EuCl₃·6H₂O was added thereto, and a precipitate was obtained. The precipitate was separated by filtration, washed with ethanol, and dried, and thus the fluorescent substance Eu(TTA)₃Phen was obtained.

### <Production of fluorescent material for converting wavelengths>

0.5 parts by mass of Eu(TTA)₃Phen obtained above as a fluorescent substance, 40 parts by mass of methyl methacrylate and 60 parts by mass of butyl acrylate as vinyl compounds, and 0.4 parts by mass of lauroyl peroxide as a radical polymerization initiator are used, and these are mixed and stirred to prepare a monomer mixture liquid (referred to as "fluorescent material for converting wavelengths 1").

### <Preparation of resin composition for converting wavelengths>

In a flask, 1000 parts by mass of ion-exchanged water and 0.01 parts by mass of polyvinyl alcohol were introduced and stirred, and the monomer mixture liquid (fluorescent material for converting wavelengths 1) was introduced to the flask. The resulting mixture was vigorously mixed, and a suspension liquid is obtained. The flask containing this suspension liquid is heated while stirred at 60°C, and thereby suspension polymerization is carried out. After the reaction is carried out for about 3 hours, the fluorescent material for converting wavelengths 1 after polymerization thus obtained is was washed with water and dried.

100g of an ethylene-vinyl acetate resin: ULTRASEN 634 manufactured by Tosoh Corp. was used as a transparent dispersion medium resin, 1.5 g of a peroxide thermal radical polymerization initiator (in this case, also works as a crosslinking agent): LUPEROX 101 manufactured by Arkema Yoshitomi, Ltd., 0.5 g of a silane coupling agent: SZ6030 manufactured by Dow Corning Toray Co., Ltd., and 2 g of the fluorescent material for converting wavelengths 1 after polymerization obtained as described above were kneaded in a roll mill at 90°C. Thus, a resin composition for converting wavelengths was obtained.

### <Production of wavelength conversion type sealing material sheet using resin composition for converting wavelengths>

About 30 g of the resin composition for converting wavelengths obtained as described above was sandwiched between release sheets, and the assembly was formed into a sheet form using a stainless steel spacer having a thickness of 0.6 mm, and using a press having the hot plate adjusted to 80°C. Thus, a wavelength conversion type sealing material sheet was obtained.

### <Evaluation of light emission moisture resistance>

The wavelength conversion type sealing material sheet obtained as described above was placed on a glass plate, and the glass plate was placed in a constant temperature and humidity tank adjusted to 85°C and 85% relative humidity. The sealing material sheet was irradiated with a handy black light of 365 nm at an appropriate interval of time. The presence or absence of red light emission was checked at 0 hour (initial), after 24 hours, 48 hours and 72 hours. The results are presented in Table 1.

### <Evaluation of turbidity>

The wavelength conversion type sealing material sheet obtained as described above was placed on a glass plate, and a PET film was mounted thereon. A sample was produced using a vacuum press laminator for exclusive use for solar cell modules, at a hot plate temperature of 150°C, for 10 minutes in a vacuum and for 15 minutes under pressure. The turbidity of this sample was measured using a haze meter (NDH-2000, manufactured by Nippon Denshoku Industries Co., Ltd.), and the turbidity value was 1.1%.

**[Table 1]**

| | Treatment of fluorescent substance | Fluorescent substance | Composition | Turbidity of sheet | Presence or absence of fluorescence | | | |
|---|---|---|---|---|---|---|---|---|
| | | | | | 0 hour | 24 hours | 48 hours | 72 hours |
| Example 1 | Vinyl compounds | Eu(TTA)₃Phen | Methyl methacrylate(40) /Butyl acrylate(60) | 1.1% | Presence | Presence | Presence | Presence |
| Example 2 | Vinyl compounds | Eu(TTA)₃Phen | Ethyl acrylate(100) | 1.2% | Presence | Presence | Presence | Presence |
| Example 3 | Vinyl compounds | Eu(TTA)₃Phen | Butyl acrylate(100) | 1.1% | Presence | Presence | Presence | Presence |
| Example 4 | Vinyl compounds | Eu(TTA)₃bpy | Methyl methacrylate(100) | 0.9% | Presence | Presence | Presence | Presence |
| Example 5 | Vinyl compounds | Eu(TTA)₃(TPPO)₂ | Methyl methacrylate(100) | 0.7% | Presence | Presence | Presence | Presence |
| Example 6 | Vinyl compounds | Eu(BFA)₃Phen | Methyl methacrylate(100) | 0.7% | Presence | Presence | Presence | Presence |
| Example 7 | Vinyl compounds | Eu(₂NTFA)₃Phen | Methyl methacrylate(100) | 0.8% | Presence | Presence | Presence | Presence |
| Comparative Example 1 | None | Eu(TTA)₃Phen | --- | 3.5% | Presence | Absence | Absence | Absence |
| Comparative Example 2 | Sol-gel glass | Eu(TTA)₃Phen | Condensation of TEOS | 1.2% | Presence | Absence | Absence | Absence |

### (Example 2)

### <Production of fluorescent material for converting wavelengths>

A fluorescent material for converting wavelengths 2 was produced in the same manner as in Example 1, except that 100 parts by mass of ethyl acrylate was used instead of 40 parts by mass of methyl methacrylate and 60 parts by mass of butyl acrylate.

### <Evaluation of light emission moisture resistance>

A wavelength conversion type sealing material sheet was produced in the same manner as in Example 1, except that the fluorescent material for converting wavelengths 2 obtained as described above was used, and an evaluation of light emission moisture resistance was similarly carried out using this sealing material sheet. The results are presented in Table 1.

Furthermore, the turbidity of the wavelength conversion type sealing material sheet thus obtained was measured in the same manner as in Example 1, and the turbidity value was 1.2%.

### (Example 3)

### <Production of fluorescent material for converting wavelengths>

A fluorescent material for converting wavelengths 3 was produced in the same manner as in Example 1, except that 100 parts by mass of butyl acrylate was used instead of 40 parts by mass or methyl methacrylate and 60 parts by mass of butyl acrylate.

### <Evaluation of light emission moisture resistance>

A wavelength conversion type sealing material sheet was produced in the same manner as in Example 1, except that the fluorescent material for converting wavelengths 3 obtained as described above was used, and an evaluation of light emission moisture resistance was similarly carried out using this sealing material sheet. The results are presented in Table 1.

Furthermore, the turbidity of the wavelength conversion type sealing material sheet thus obtained was measured in the same manner as in Example 1, and the turbidity value was 1.1%.

### (Example 4)

### <Production of fluorescent material for converting wavelengths>

A fluorescent material for converting wavelengths 4 was produced in the same manner as in Example 1, except that Eu(TTA)₃bpy was used as the fluorescent substance instead of Eu(TTA)₃Phen, and 100 parts by mass of methyl methacrylate was used as the vinyl compound instead of 40 parts by mass methyl methacrylate and 60 parts by mass of butyl acrylate.

Meanwhile, bpy stands for 2,2'-bipyridine.

### <Evaluation of light emission moisture resistance,

A wavelength conversion type sealing material sheet was produced in the same manner as in Example 1, except that the fluorescent material for converting wavelengths 4 obtained as described above was used, and an evaluation of light emission moisture resistance was similarly carried out using this sealing material sheet. The results are presented in Table 1.

Furthermore, the turbidity of the wavelength conversion type sealing material sheet thus obtained was measured in the same manner as in Example 1, and the turbidity value was 0.9%.

### (Example 5)

### <Production of fluorescent material for converting wavelengths>

A fluorescent material for converting wavelengths 5 was produced in the same manner as in Example 1, except that Eu(TTA)₃(TPPO)₂ was used as the fluorescent substance instead of Eu(TTA)₃Phen, and 100 parts by mass of methyl methacrylate was used as the vinyl compound instead of 40 parts by mass methyl methacrylate and 60 parts by mass of butyl acrylate.

Meanwhile, TPPO stands for triphenylphosphine oxide.

### <Evaluation of light emission moisture resistance>

A wavelength conversion type sealing material sheet was produced in the same manner as in Example 1, except that the fluorescent material for converting wavelengths 5 obtained as described above was used, and an evaluation of light emission moisture resistance was similarly carried out using this sealing material sheet. The results are presented in Table 1.

Furthermore, the turbidity of the wavelength conversion type sealing material sheet thus obtained was measured in the same manner as in Example 1, and the turbidity value was 0.7%.

### (Example 6)

### <Production of fluorescent material for converting wavelengths>

A fluorescent material for converting wavelengths 6 was produced in the same manner as in Example 1, except that Eu(BFA)₃phen was used as the fluorescent substance instead of Eu(TTA)₃Phen, and 100 parts by mass of methyl methacrylate was used as the vinyl compound instead of 40 parts by mass methyl methacrylate and 60 parts by mass of butyl acrylate.

Meanwhile, BFA stands for 4,4,4-trifluoro-1-phenyl-1,3-butanedione.

### <Evaluation of light emission moisture resistance>

A wavelength conversion type sealing material sheet was produced in the same manner as in Example 1, except that the fluorescent material for converting wavelengths 6 obtained as described above was used, and an evaluation of light emission moisture resistance was similarly carried out using this sealing material sheet. The results are presented in Table 1.

Furthermore, the turbidity of the wavelength conversion type sealing material sheet thus obtained was measured in the same manner as in Example 1, and the turbidity value was 0.7%.

### (Example 7)

### <Production of fluorescent material for converting wavelengths>

A fluorescent material for converting wavelengths 7 was produced in the same manner as in Example 1, except that Eu(2NTFA)₃phen was used as the fluorescent substance instead of Eu(TTA)₃Phen, and 100 parts by mass of methyl methacrylate was used as the vinyl compound instead of 40 parts by mass methyl methacrylate and 60 parts by mass of butyl acrylate.

Meanwhile, 2NTFA stands for 4,4,4-trifluoro-1-(2-naphthyl)-1,3-butanedione.

### <Evaluation of light emission moisture resistance>

A wavelength conversion type sealing material sheet was produced in the same manner as in Example 1, except that the fluorescent material for converting wavelengths 7 obtained as described above was used, and an evaluation of light emission moisture resistance was similarly carried out using this sealing material sheet. The results are presented in Table 1.

Furthermore, the turbidity of the wavelength conversion type sealing material sheet thus obtained was measured in the same manner as in Example 1, and the turbidity value was 0.8%.

### (Comparative Example 1)

### <Preparation of resin composition for converting wavelengths containing fluorescent substance that is not dispersed in vinyl compound>

100 g of an ethylene-vinyl acetate resin: ULTRASEN 634 manufactured by Tosoh Corp was used as a transparent dispersion medium resin, and 1.5 g of a peroxide thermal radical polymerization initiator: LUPEROX 101 manufactured by Arkema Yoshitomi, Ltd., 0.5 g of a silane coupling agent: SZ6030 manufactured by Dow Corning Toray Co., Ltd., and 2 g of the fluorescent material Eu(TTA)₃Phen were kneaded in a roll mill at 100°C. Thus, a resin composition for converting wavelengths was obtained.

### <Production of wavelength conversion type sealing material sheet using fluorescent substance that is not dispersed in vinyl compound>

About 30 g of the resin composition containing a fluorescent substance that is not dispersed in a vinyl compound, obtained as described above, was sandwiched between release sheets, and the assembly was formed into a sheet form using a stainless steel spacer having a thickness of 0.6 mm, and using a press having the hot plate adjusted to 80°C. Thus, a wavelength conversion type sealing material sheet was obtained.

### <Evaluation of light emission moisture resistance>

An evaluation of light emission moisture resistance was carried out in the same manner as in Example 1, using the wavelength conversion type sealing material sheet obtained as described above. The results are presented in Table 1.

Furthermore, the turbidity of the wavelength conversion type sealing material sheet thus obtained was measured in the same manner as in Example 1, and the turbidity value was 3.5%.

### (Comparative Example 2)

### <Production of fluorescent substance coated with sol-gel glass>

A solution for sol-gel was prepared using Eu(TTA)₃Phen obtained as described above, and using the materials indicated in Table 2 in the incorporation amounts indicated in Table 2.

The materials of (a) to (d) shown in the table were mixed, and on the other hand, the material of (e) to (f) were mixed, at the molar ratios indicated in Table 2 for both mixtures. The mixtures were thoroughly mixed and stirred, and then the two mixtures were mixed and stirred For 2 hours. Thus, a coated fluorescent substance solution was obtained. This solution was poured in a vat made of TEFLON (registered trademark), and volatile components were removed therefrom over 5 hours in an oven at 120°C.

**[Table 2]**

| Materials | | Molecular weight | Mole Ratio |
|---|---|---|---|
| (a) | Eu(TTA)₃Phen | 995.7 | 0.05 |
| (b) | N,N-dimethylformamide | 73.1 | 4 |
| (c) | Tetramethyl | 208.3 | 1 |
| (d) | Water | 18.0 | 4 |
| (e) | Ethanol | 46.1 | 4 |
| (f) | Acetic acid | 60.1 | 0.01 |

### <Preparation of resin composition based on sol-gel glass>

100 g of an ethylene-vinyl acetate resin: ULTRASEN 634 manufactured by Tosoh Corp was used as a transparent dispersion medium resin, and 1.5 g of a peroxide thermal radical polymerization initiator: LUPEROX 101 manufactured by Arkema Yoshitomi, Ltd., 0.5 g of a silane coupling agent: SZ6030 manufactured by Dow Corning Toray Co., Ltd., and 2 g of the fluorescent material coated with sol-gel glass were kneaded in a roll mill at 100°C. The resultant was spread on a release sheet and was cooled to room temperature. Thus, a resin composition was obtained.

### <Production of wavelength conversion type sealing material sheet based on sol-gel glass>

About 30 g of the resin composition obtained as described above was sandwiched between release sheets, and the assembly was formed into a sheet form using a stainless steel spacer having a thickness of 0.6 mm, and using a press having the hot plate adjusted to 80°C. Thus, a wavelength conversion type sealing material sheet was obtained.

### <Evaluation of light emission moisture resistance>

An evaluation of light emission moisture resistance was carried out in the same manner as in Example 1, using the wavelength conversion type sealing material sheet obtained as described above. The results are presented in Table 1.

Furthermore, the turbidity of the wavelength conversion type sealing material sheet thus obtained was measured in the same manner as in Example 1, and the turbidity value was 1.2%.

### INDUSTRIAL APPLICABILITY

According to the present invention, there can be provided a fluorescent material for converting wavelengths and a resin composition for converting wavelengths capable of converting a light that contributes less to solar energy generation in the incident solar radiation, to a wavelength that contributes significantly to energy generation, as well as capable of utilizing the solar radiation efficiently and stably without deteriorating, when the fluorescent material for converting wavelengths and the resin composition for converting wavelengths are applied to a solar cell module.

## Claims

1. A fluorescent material for converting wavelengths used in a light transmitting layer of a solar cell module, being obtainable by mixing a fluorescent substance and a vinyl compound.

2. The fluorescent material for converting wavelengths according to claim 1, wherein the vinyl compound is an acrylic monomer and/or a methacrylic monomer.

3. The fluorescent material for converting wavelengths according to claim. 1 or 2, wherein the fluorescent substance is a europium complex.

4. A resin composition for converting wavelengths comprising the fluorescent material for converting wavelengths according to any one of claims I to 3, mixed in a transparent dispersion medium resin,
wherein the vinyl compound is polymerized before the fluorescent material for converting wavelengths is mixed with the transparent dispersion medium resin.

5. The resin composition for converting wavelengths according to claim 4, wherein the fluorescent materials for converting wavelengths is mixed in an amount of 0.00001% to 1% by mass, in terms of the mass concentration of the fluorescent substance, relative to the total amount of non-volatile components.

6. A solar cell module, using the resin composition for converting wavelengths according to claim 4 or 5 as at least one layer of light transmitting layers.

7. A method for producing the resin composition for converting wavelengths according to claim 4 or 5, comprising the steps of:
mixing a fluorescent substance and an acrylic monomer and/or a methacrylic monomer to obtain a fluorescent material for converting wavelengths;
polymerizing the acrylic monomer and/or methacrylic monomer of the fluorescent material for converting wavelengths to obtain a fluorescent material for converting wavelengths after polymerization; and
mixing the fluorescent material for converting wavelengths after polymerization, with a transparent dispersion medium resin to obtain the resin composition for converting wavelengths.

8. A method for producing a solar cell module, comprising the step of:
forming the resin composition for converting wavelengths according to claim 4 or 5 into a sheet form, and allowing the sheet to constitute at least one layer of the light transmitting layers of a solar cell module.

9. A method for producing a solar cell module, comprising the step of:
forming the resin composition for converting wavelengths according to claim 4 or 5 into a film form, pasting the film on the inner side of a photovoltaic cell or a protective glass, and allowing the film to constitute at least one layer of the light transmitting layers of a solar cell module.
